# EUROPÄISCHE PATENTSCHRIFT

(11) **EP 2 054 955 B1**
(45) Veröffentlichungstag und Bekanntmachung des Hinweises auf die Patenterteilung: **23.05.2018**
(21) Anmeldenummer: 07801285.3
(22) Anmeldetag: 28.08.2007
(51) Int. Cl.: H05B 33/08, H01L 51/52

(54) **LICHTEMITTIERENDE VORRICHTUNG**
LIGHT-EMITTING DEVICE
DISPOSITIF ÉMETTEUR DE LUMIÈRE

(30) Priorität: 22.09.2006 DE 102006044852; 03.11.2006 DE 102006052029
(43) Veröffentlichungstag der Anmeldung: 06.05.2009
(73) Patentinhaber: OSRAM OLED GmbH, 93049 Regensburg (DE)
(72) Erfinder: SCHINDLER, Florian, 83278 Traunstein (DE); KLEIN, Markus, 93105 Tegernheim (DE); KRUMMACHER, Benjamin Claus, 93057 Regensburg (DE)
(74) Vertreter: Epping - Hermann - Fischer
(86) Internationale Anmeldenummer: PCT/DE2007/001534
(87) Internationale Veröffentlichungsnummer: WO 2008/034405

(56) Entgegenhaltungen:
- WO-A-2005/008800
- WO-A-2007/119200
- DE-U1-202005 000 979
- GB-A- 2 329 506
- US-A- 5 902 688
- US-A1- 2004 206 965
- US-A1- 2005 270 464

## Beschreibung

Die Erfindung betrifft eine lichtemittierende Vorrichtung mit zumindest einer lichtemittierenden Funktionsschicht.

Die Druckschrift DE 202005000979 U1 beschreibt ein elektrooptisches Element, beispielsweise eine OLED, mit einer Widerstandsanpassungsschicht.

Die Druckschrift WO 2005/008800 A1 beschreibt eine OLED, die in ihrem Substrat oder in der ersten Elektrode metallische Leiterstrukturen aufweist zur Erzeugung einer homogenen Leuchtdichte.

Die Druckschrift GB 2329506 A beschreibt ein organisches Licht emittierendes Bauelement, das eine erste und zweite Anodenschicht aufweist, die beide streifenförmig strukturiert sind.

Die Druckschrift US 2004/206965 A1 beschreibt eine Feedback-Enhanced-OLED, die eine laterale Modulation des Brechungsindex aufweist, die auch eine Modulation der elektrischen Eigenschaften mit sich führen kann.

In der Druckschrift US 5,902,688 A wird ein elektrolumineszierendes Displayelement mit einem strukturierten Isolator angegeben.

Die Druckschrift US 2005/270464 A1 betrifft ein Beleuchtungssystem, mit einer ersten Elektrode, einer zweiten Elektrode, einer Schicht mit einer Licht emittierenden Substanz zwischen der ersten Elektrode und der zweiten Elektrode, einer isolierenden Schicht, die gitterförmig über einem Substrat aufgebracht ist und eine fluoreszierende Substanz enthält, und einer elektrischen Leitung über der isolierenden Schicht. Die isolierende Schicht und die elektrische Leitung sind mit der ersten Elektrode bedeckt, so dass sich die erste Elektrode und die elektrische Leitung kontaktieren.

Lichtemittierende Vorrichtungen, wie beispielsweise eine OLED, zeigen ein durch ihre planare Struktur bestimmtes flächiges, meist lambertsches Abstrahlprofil. Aus diesen planaren lichtemittierenden Vorrichtungen können z. B. großflächige Beleuchtungseinheiten (Panele) zusammengestellt werden. Für das menschliche Auge kann eine homogene Strahlungsfläche irritierend wirken, da die Raumtiefe verloren geht bzw. der Lichteindruck monoton wirkt.

Aufgabe der Erfindung ist es, für lichtemittierende Vorrichtungen Möglichkeiten anzugeben, um die oben genannten Nachteile zu vermindern.

Diese Aufgabe wird durch eine lichtemittierende Vorrichtung gemäß den unabhängigen Ansprüchen 1, 14 gelöst. Besonders vorteilhafte Ausgestaltungen und weitere lichtemittierende Vorrichtungen sind Gegenstand weiterer Ansprüche.

In lichtemittierenden Vorrichtungen gemäß eines Ausführungsbeispiels der Erfindung werden elektrisch leitfähige Leiterbahnen eingesetzt, die im elektrischen Kontakt mit zumindest einer Elektrodenfläche stehen.

Diese elektrisch leitfähigen Leiterbahnen werden mit einer Elektrodenfläche einer lichtemittierenden Vorrichtung kombiniert und mit zeitlich variablen und/oder mit unterschiedlich hohen Strömen angesteuert. Dadurch erhält man eine lichtemittierende Vorrichtung mit zeitlich variabel einstellbarer Leuchtdichte. Diese Vorrichtung weist ein Substrat auf, auf dem eine erste Elektrodenfläche aufgebracht ist. Darauf befinden sich mindestens zwei elektrisch leitfähige Leiterbahnen, die im elektrischen Kontakt mit der ersten Elektrodenfläche stehen. Auf den elektrisch leitfähigen Leiterbahnen befindet sich zumindest eine organische Schicht, die eine lichtemittierende Funktionsschicht umfasst, und darauf eine zweite Elektrodenfläche. Die mindestens zwei elektrisch leitfähigen Leiterbahnen sind dabei so eingerichtet, dass sie mit zeitlich variablen und/oder unterschiedlichen hohen elektrischen Strömen angesteuert werden können, wobei eine variierende Leuchtdichte resultiert. Weiterhin sind die zumindest zwei elektrisch leitenden Leiterbahnen so dick, dass sie die erste Elektrodenfläche, die organische Schicht und die zweite Elektrodenfläche durchstoßen. Darüber hinaus sind die zumindest zwei elektrisch leitenden Leiterbahnen an den seitlichen Rändern zur organischen Schicht und der zweiten Elektrodenfläche hin mit einer nicht-leitenden Polymerschicht ummantelt. Durch die Pulsform, Steilheit, Höhe und Taktung des angelegten Stroms kann die vorhandene nichtlineare Abhängigkeit der Leuchtdichte zur Dynamisierung der Beleuchtung genutzt werden. Die individuelle elektronische Ansteuerung erlaubt eine Anpassung an die gewünschte Belebtheit.

Diese Belebtheit bzw. Vitalität der Beleuchtung kann durch eine örtliche Fluktuation der Helligkeit erzeugt werden. Die Fluktuation kann örtlich statisch oder dynamisch hervorgerufen sein. Dadurch kann das Auge die Raumtiefe auflösen und zusätzlich eine Lebendigkeit der Raumbeleuchtung erfahren.

Bei dieser lichtemittierenden Vorrichtung mit variabler Ansteuerung kann es sich in einer vorteilhaften Ausführung der Erfindung auch um eine OLED handeln, vorzugsweise um eine großflächige OLED.

Eine OLED umfasst eine erste und zweite Elektrodenfläche, die als eine Kathode und eine Anode geschaltet sein können, zwischen denen sich mindestens eine organische funktionelle Schicht befindet, die z. B. eine Emissions-, eine Elektronen- und eine Lochtransportschicht beinhalten kann. Von der Kathode werden Elektroden und von der Anode positive Ladungen (sog. Löcher) in die Emissionsschicht bei Anlegen einer Spannung injiziert. Durch die Rekombination dieser Ladungen in der Emissionsschicht wird Licht erzeugt.

Vorteilhafterweise sind die mindestens zwei elektrisch leitfähigen Leiterbahnen dabei in einem Abstand von 5 µm bis 10 cm, vorzugsweise von 500 µm bis 1 cm, auf der Elektrodenfläche, gegebenenfalls auch in unterschiedlicher Länge angeordnet. Sie können getrennt voneinander elektrisch angesteuert werden. Dazu sind in einer günstigen Ausgestaltung der Erfindung die Leiterbahnen elektrisch leitend mit einer Stromquelle verbunden, wobei das Ausgangssignal der Stromquelle auf eine für jede Leiterbahn individuelle Modulationsfrequenz einstellbar sein kann. Diese Modulationsfrequenz beträgt vorteilhafterweise unter 200 Hz, vorzugsweise unter 100 Hz. Es ist auch eine statistisch fluktuierende Frequenz und/oder Amplitude vorstellbar.

Gemäß einer Weiterbildung der Erfindung weisen die Leiterbahnen elektrische Anschlüsse zur Kontaktierung einer Stromquelle auf, wobei die Anschlüsse an unterschiedlichen Enden der Leiterbahnen vorhanden sein können. In einer weiteren günstigen Ausgestaltung der Erfindung sind die Leiterbahnen in mindestens zwei Gruppen zusammengefasst, wobei die Leiterbahnen einer Gruppe elektrisch leitend miteinander verbunden sind. Dabei ist es günstig, wenn jede Gruppe mit einer anderen Stromquelle elektrisch leitend verbunden ist und die Ausgangssignale der Stromquellen unabhängig voneinander modulierbar sind. Damit ist eine zeitversetzte Helligkeitsmodulation der Gruppen möglich. Die Gruppen können auch elektrisch leitend mit einer gemeinsamen Stromquelle verbunden sein, deren Ausgangssignal modulierbar ist. Damit kann ein ortsgebundenes Flackern erzeugt werden. Der Vorteil dieser Ausführungsformen ist, dass die Kontaktierung der Leiterbahnen erleichtert wird, wenn sie in Gruppen zusammengefasst sind.

Ein weiteres vorteilhaftes Merkmal einer weiteren Ausführungsform der Erfindung ist eine zusätzliche lichtauskoppelnde Schicht, die eine Vielzahl von optischen Elementen enthält und im Strahlengang der lichtemittierenden Funktionsschicht angeordnet ist. Die optischen Elemente sind dabei vorteilhafterweise auf einer Hauptoberfläche der lichtauskoppelnden Schicht vorhanden. Die optischen Elemente haben günstigerweise eine über die Oberfläche unterschiedliche Verteilung und/oder eine unterschiedliche geometrische Ausformung. Sie sind dabei vorteilhafterweise ausgewählt aus einer Gruppe, die aus Linsen, Prismen, Zylindern, lichtfilternden Einheiten und Streupartikeln besteht. Eine solche Kombination aus lichtauskoppelnder Schicht und lichtemittierender Vorrichtung dient dazu, eine örtliche, statische Variation der Helligkeit zu erzeugen, da die planare lichtauskoppelnde Schicht räumlich unterschiedlich strukturiert ist und somit aufgrund der unterschiedlich strukturierten und unterschiedliche über die Oberfläche verteilten optischen Elemente eine örtliche, statische Variation der Leuchtdichte resultieren kann. Auch der Farbort kann durch die lichtauskoppelnde Schicht periodisch moduliert werden, beispielsweise durch den Spitzenwinkel eines Prismas oder durch lichtfilternde Einheiten. Diese statische Variation der Helligkeit kann mit der dynamischen Variation, wie oben beschrieben, kombiniert werden.

Ein weiteres vorteilhaftes Merkmal einer weiteren Ausführungsform der Erfindung ist zusätzlich eine erste Ladungstransportschicht, die sich zwischen der ersten Elektrodenfläche und der zumindest einen lichtemittierenden Funktionsschicht befindet, und Teilbereiche mit unterschiedlichen elektrischen Leitfähigkeiten aufweist. Vorzugsweise handelt es sich dabei um lateral alternierende Bereiche, die abwechselnd eine höhere und eine geringere Leitfähigkeit aufweisen. Dazu weist die Vorrichtung einen Dotierstoff auf, dessen Verteilung in den Teilbereichen der Ladungstransportschicht variiert. Der Vorteil dieses Merkmals besteht darin, dass eine räumliche Dotierungsmodifikation zu einer örtlichen Variation der Leitfähigkeit führt. In einer vorteilhaften Weiterbildung kann sich zwischen der lichtemittierenden Funktionsschicht und der zweiten Elektrodenfläche eine zweite Ladungstransportschicht befinden, wobei die zweite Ladungstransportschicht ebenfalls unterschiedliche Teilbereiche mit unterschiedlichen Leitfähigkeiten aufweist. Vorzugsweise handelt es sich um lateral alternierende Bereiche, die abwechselnd eine höhere und eine geringere Leitfähigkeit aufweisen. Auch die zweite Ladungstransportschicht weist einen Dotierstoff auf, dessen Verteilung in den unterschiedlichen Teilbereichen der Ladungstransportschicht variiert. Die erste und zweite Ladungstransportschicht ist ausgewählt aus Elektronentransportschichten und Lochtransportschichten. Die räumliche Dotierungsmodifikation führt dabei zu einer örtlichen Variation der Leitfähigkeit und diese wiederum zu einer örtlichen Variation der Leuchtdichte. Damit wird dazu beigetragen, dass der Betrachter eine belebtere Beleuchtung bzw. eine ortsabhängige Intensitätsvariation wahrnimmt.

Weiterhin kann zusätzlich eine in lateraler Richtung variierende elektrische Leitfähigkeit der Oberfläche der ersten Elektrodenfläche ein weiteres Merkmal der Erfindung sein. Die Oberfläche der ersten Elektrodenfläche weist dabei eine in lateraler Richtung variierende Oberflächenmodifikation auf. Der Vorteil dieses Merkmals ist, dass eine örtliche Modifikation der Oberflächenleitfähigkeit der Elektrode eine entsprechende örtliche Variation der Ladungsträgerdichte bewirkt. Vorteilhafterweise kann zusätzlich die Oberfläche der zweiten Elektrodenfläche eine in lateraler Richtung variierende elektrische Leitfähigkeit aufweisen, wobei diese durch eine in lateraler Richtung variierende Oberflächenmodifikation erreicht wird. Die laterale Oberflächenmodifikation kann beispielsweise durch lokale Plasmabehandlung erzeugt werden und führt zu einer lokal modifizierten Ladungsträgeraustrittsarbeit bzw. einem lokal modifizierten Oberflächenwiderstand. Die örtliche Variation der Ladungsträgerdichte auf den Oberflächen der Elektroden bewirkt eine lateral variierende Leitfähigkeit, die wiederum eine lateral variierende Leuchtdichte verursacht, die der Betrachter als Lebendigkeit der Beleuchtung wahrnimmt. Damit wird zusätzlich zu der oben erwähnten dynamischen Variation der Leuchtdichte eine statische Variation der Leuchtdichte bedingt.

Es wird weiterhin eine lichtemittierende Vorrichtung mit variierender Leuchtdichte beschrieben, die ein Substrat, eine erste Elektrodenfläche, zumindest eine lichtemittierende Funktionsschicht, eine zweite Elektrodenfläche und eine lichtauskoppelnde Schicht im Strahlengang der lichtemittierenden Funktionsschicht umfasst. Dabei weist die lichtauskoppelnde Schicht eine Vielzahl von optischen Elementen mit über der Oberfläche unterschiedlicher Verteilung und/oder geometrischer Ausformung und/oder optischer Transmissivität auf. Vorteilhafterweise sind die optischen Elemente ausgewählt aus Linsen, Prismen, Zylindern, lichtfilternden Einheiten und Streupartikeln und sind auf der Hauptoberfläche bzw. Lichtaustrittfläche der lichtauskoppelnden Schicht angeordnet. Bei dieser lichtemittierenden Vorrichtung handelt es sich günstigerweise um eine OLED. Eine solche Kombination aus lichtauskoppelnder Schicht und lichtemittierender Vorrichtung dient dazu, eine örtliche, statische Variation der Helligkeit zu erzeugen, da die planare lichtauskoppelnde Schicht räumlich unterschiedlich strukturiert ist und somit aufgrund der unterschiedlich strukturierten und unterschiedlich über die Oberfläche verteilten optischen Elemente eine örtliche, statische Variation der Leuchtdichte aufgrund der örtlich unterschiedlichen Intensität der ausgekoppelten Strahlung resultieren kann. Auch der Farbort kann durch die lichtauskoppelnde Schicht periodisch moduliert werden, beispielsweise durch den Spitzenwinkel eines Prismas oder durch lichtfilternde Einheiten.

Es wird weiterhin eine lichtemittierende Vorrichtung beschrieben, die ein Substrat, eine erste Elektrodenfläche, eine erste Ladungstransportschicht, zumindest eine lichtemittierende Funktionsschicht und eine zweite Elektrodenfläche umfasst. Die erste Ladungstransportschicht kann dabei Teilbereiche mit unterschiedlicher elektrischer Leitfähigkeit aufweisen. Dabei handelt es sich vorzugsweise um lateral alternierende Bereiche, die abwechselnd eine höhere und eine geringere Leitfähigkeit aufweisen. Vorteilhafterweise weist die erste Ladungstransportschicht einen Dotierstoff auf, dessen Verteilung in den Teilbereichen der ersten Ladungstransportschicht variiert. In einer vorteilhaften Weiterbildung dieses Merkmals kann sich zwischen der zumindest einen lichtemittierenden Funktionsschicht und der zweiten Elektrodenfläche eine zweite Ladungstransportschicht befinden, die ebenfalls Teilbereiche mit unterschiedlicher elektrischer Leitfähigkeit aufweist. Dabei handelt es sich vorzugsweise um in lateraler Richtung alternierende Bereiche, die abwechselnd eine höhere und eine geringere Leitfähigkeit aufweisen. Die in lateraler Richtung alternierenden Bereiche weisen einen Dotierstoff auf, dessen Verteilung in den Teilbereichen der zweiten Ladungstransportschicht variiert. Der Vorteil dieses Merkmals ist, dass eine räumliche Dotierungsmodifikation zu einer örtlichen Variation der Leitfähigkeit führt. Die Verteilung des Dotierstoffes liegt dabei günstigerweise in einem Bereich weniger Prozent, vorzugsweise weniger als 15 Prozent des Maximalwertes der Dotierungskonzentration. Bei dieser lichtemittierenden Vorrichtung handelt es sich vorteilhafterweise um eine OLED.

Eine weitere Ausführungsform der Erfindung betrifft weiterhin eine lichtemittierende Vorrichtung mit variierender Leuchtdichte, die ein Substrat, eine erste Elektrodenfläche, zumindest eine lichtemittierende Funktionsschicht und eine zweite Elektrodenfläche umfasst, wobei die erste und die zweite Elektrodenfläche eine in lateraler Richtung variierende elektrische Leitfähigkeit bzw. eine lokal modifizierte Ladungsträgeraustrittsarbeit aufweist. Die Oberfläche der ersten und zweiten Elektrodenfläche weisen dabei in lateraler Richtung variierende Oberflächenmodifikationen auf, wobei die Oberflächenmodifikationen durch eine strukturierte Photolackschicht gebildet sind, welche auf der ersten und zweiten Elektrodenfläche aufgebracht ist. Vorteilhafterweise umfasst die lichtemittierende Vorrichtung eine OLED. Die örtliche Variation der Ladungsträgerdichte auf den Oberflächen der Elektroden bewirkt eine lateral variierende Leitfähigkeit, die wiederum eine lateral variierende Leuchtdichte verursacht, die der Betrachter als Lebendigkeit der Beleuchtung wahrnimmt.

Anhand der Figuren und der Ausführungsbeispiele soll die Erfindung näher erläutert werden:
Figur 1a zeigt einen Querschnitt des Aufbaus einer lichtemittierenden Vorrichtung gemäß eines Vergleichsbeispiels.
Figur 1b zeigt einen Querschnitt des Aufbaus einer lichtemittierenden Vorrichtung gemäß eines Ausführungsbeispiels.
In den Figuren 2a bis 2d sind Aufsichten auf die lichtemittierende Funktionsschicht mit variabel ansteuerbaren Leiterbahnen zu sehen.
Figur 3 zeigt die Aufsicht auf eine lichtauskoppelnde Schicht mit optischen Elementen.
In den Figuren 4a bis 4c sind Querschnitte verschiedener Vergleichsbeispiele einer lichtemittierenden Vorrichtung zu sehen, die Schichten mit lateral variierender elektrischer Leitfähigkeit aufweisen.
Figur 4d zeigt einen Querschnitt eines Ausführungsbeispiels einer lichtemittierenden Vorrichtung.

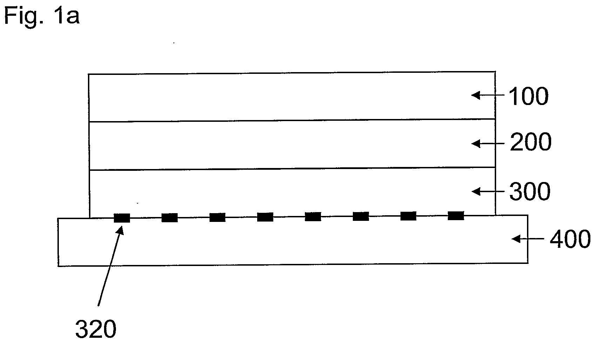

Figur 1a zeigt den Querschnitt eines Beispiels einer Vorrichtung. Hierbei sind auf einem Substrat (400) elektrisch leitfähige Leiterbahnen (320) angeordnet, darauf eine erste Elektrodenfläche (300), darauf zumindest eine organische Schicht (200) und eine zweite Elektrodenfläche (100). Die organische Schicht (200) kann lichtemittierende Funktionsschichten und/oder Ladungstransportschichten umfassen. Wenn an die Leiterbahnen Spannung angelegt wird, erhöhen sie örtlich die Leitfähigkeit der ersten Elektrodenfläche.

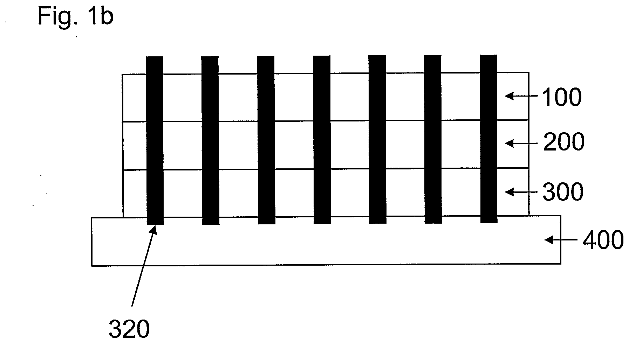

Figur 1b zeigt eine erfindungsgemäße Variation des Beispiels aus Figur 1a. Hier sind die Leiterbahnen(320) so dick, dass sie die erste Elektrodenfläche (300), die organische Schicht (200) und die zweite Elektrodenfläche (100) durchstoßen. In dieser Ausführungsform sollten die Leiterbahnen vorteilhafterweise an den seitlichen Rändern zur organischen Schicht und der zweiten Elektrodenfläche hin mit einer isolierenden Schicht, beispielsweise einer nicht-leitenden Polymerschicht, ummantelt sein. Generell können die Leiterbahnen eine variable Dicke haben und an einer der Oberflächen der ersten Elektrodenfläche, in der ersten Elektrodenfläche oder über die Dicke der ersten Elektrodenfläche hinausragend vorhanden sein.

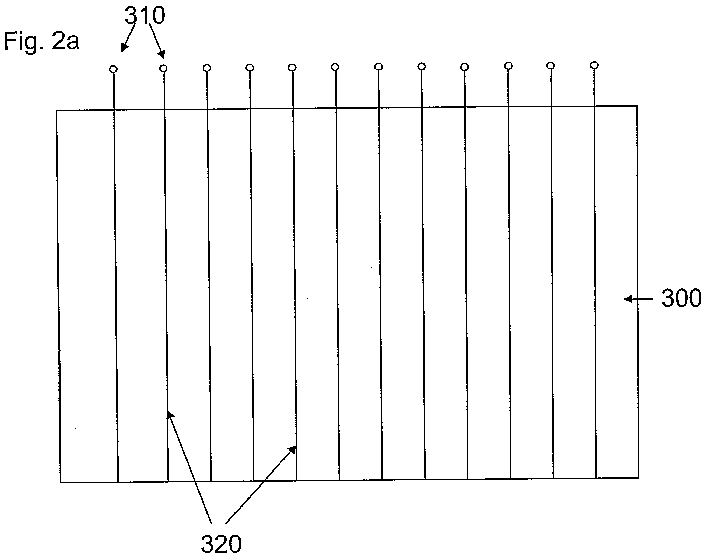

Figur 2a zeigt die Aufsicht auf die erste Elektrodenfläche (300) aus Figur 1, auf der elektrische Leiterbahnen (320) mit elektrischen Anschlüssen (310) aufgebracht sind. Die Leiterbahnen können sich auf der Oberfläche der Elektrodenfläche befinden oder in der Elektrodenfläche oder über die Dicke der ersten Elektrodenfläche hinausragen. Insbesondere können sie zwischen dem Substrat (400) und der ersten Elektrodenfläche (300) angeordnet sein, wie in Fig. 1 gezeigt, oder auch zwischen der ersten Elektrodenfläche (300) und der zumindest einen organischen Funktionsschicht (200). Das Material der Leiterbahnen kann elektrisch leitfähige Metalle umfassen. Die Leiterbahnen sind vorzugsweise in einem Abstand von 500 µm bis zu einem 1 cm angeordnet und können unterschiedlich lang sein, d.h. sie müssen nicht über die gesamte Fläche der Elektrodenfläche reichen, können jedoch vorzugsweise möglichst lang sein. Jede dieser Leiterbahnen hat einen eigenen elektrischen Anschluss, so dass sie einzeln ansteuerbar sind. Die Modulationsfrequenz sollte dabei jeweils 100 Hz nicht überschreiten, um für den äußeren Betrachter einen sichtbaren Effekt zu bewirken. Durch die individuelle, variable Ansteuerung der Leiterbahnen wird eine dynamisierte Beleuchtung erzeugt, die an die gewünschte Belebtheit angepasst werden kann.

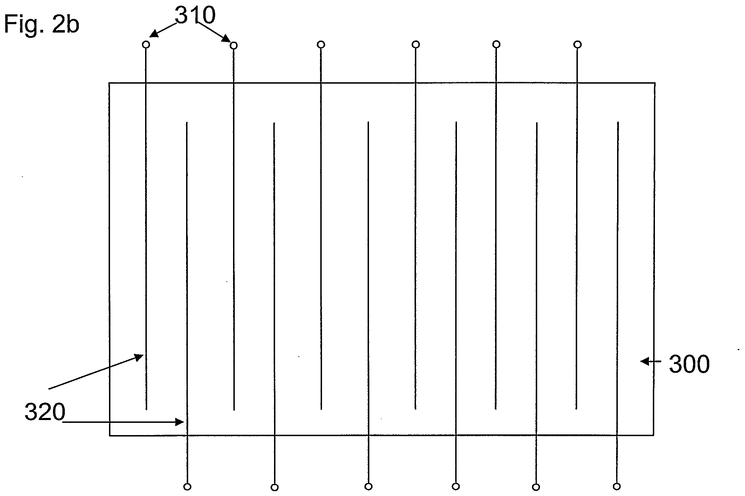

Figur 2b zeigt ebenfalls die Aufsicht auf die erste Elektrodenfläche (300), auf der elektrische Leiterbahnen (320) mit elektrischen Anschlüssen (310) aufgebracht sind. Diese Elektrodenfläche kann z. B. anstelle der Elektrodenfläche aus Fig. 2a als erste Elektrodenfläche in der Vorrichtung der Figur 1 vorhanden sein oder Teile der in Fig. 2b gezeigten Leiterbahnen können mit Teilen der in Fig. 2a gezeigten Leiterbahnen in einer Elektrodenfläche kombiniert werden. In dieser weiteren vorteilhaften Ausführung der Erfindung sind die Leiterbahnen (320) mit den jeweils zugehörigen Anschlüssen (310) so angeordnet, dass sich die Anschlüsse abwechselnd auf beiden Seiten der Elektrodenfläche befinden. Diese Ausführung ist vorteilhaft, da der individuelle Anschluss der Leiterbahnen an Stromquellen erleichtert wird.

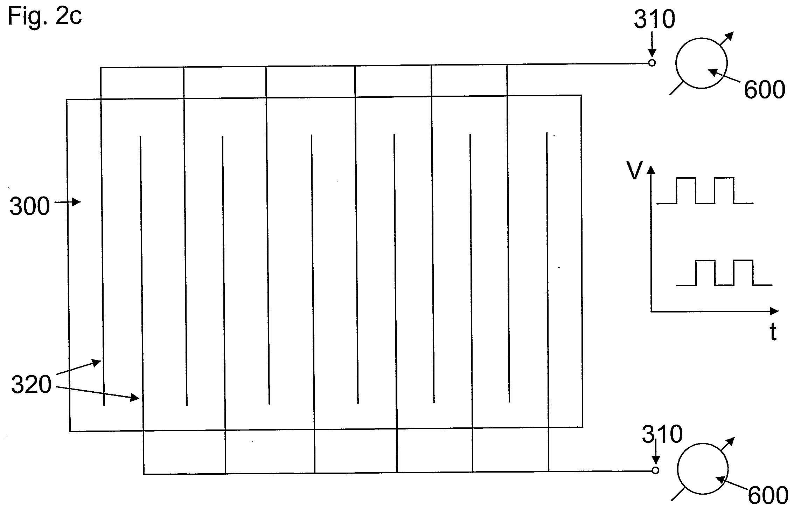

Figur 2c zeigt die Aufsicht auf die erste Elektrodenfläche (300), die z. B. in der Vorrichtung der Figur 1 als Elektrodenfläche verwendet werden könnte, auf der elektrische Leiterbahnen (320) mit elektrischen Anschlüssen (310) aufgebracht sind. Die Leiterbahnen können sich auf der Oberfläche der Elektrodenfläche befinden oder in der Elektrodenfläche oder über die erste Elektrodenfläche hinausreichen. Insbesondere können sie zwischen dem Substrat (400) und der ersten Elektrodenfläche (300) angeordnet sein, wie in Fig. 1 gezeigt, oder auch zwischen der ersten Elektrodenfläche (300) und der zumindest einen organischen Funktionsschicht (200). In dieser weiteren vorteilhaften Ausführung der Erfindung, sind die Leiterbahnen (320) auf der Elektrodenfläche (300) in Gruppen zusammengefasst, die elektrisch leitend miteinander verbunden sind. Wie in Figur 2c gezeigt, können die mindestens zwei Gruppen beispielsweise kammartig ineinander verschoben sein. Jede der Gruppe hat einen eigenen für alle Leiterbahnen einer Gruppe gemeinsamen elektrischen Anschluss (310) der von einer Stromquelle (600) angesteuert wird. Durch Anlegen einer von der Zeit t abhängigen Spannung V kann jede Gruppe von Leiterbahnen mit Pulsfrequenzen angesteuert werden, wobei die Pulsform, Steilheit, Höhe und Taktung der angelegten Spannungen die nichtlineare Abhängigkeit der Leuchtdichte zur Dynamisierung der Beleuchtung nutzt.

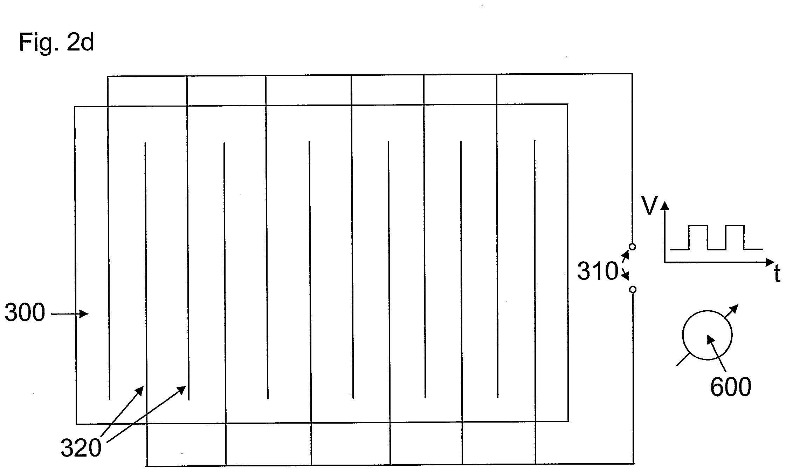

Figur 2d zeigt eine weitere vorteilhafte Ausführungsform einer Elektrodenfläche mit Leiterbahnen. Hier ist die Aufsicht auf eine weitere Ausführungsform der ersten Elektrodenfläche (300) der Vorrichtung der Figur 1 mit elektrischen Leiterbahnen (320) und elektrischen Anschlüssen (310) zu sehen, die ebenfalls zwei Gruppen von Leiterbahnen (320) bilden, die kammartig ineinander verschoben auf der ersten Elektrodenfläche (300) angeordnet sind. Die Gruppen von Leiterbahnen sind jeweils elektrisch leitend miteinander verbunden, ihre Anschlüsse (310) sind in dieser Ausführungsform jedoch mit nur einer Stromquelle (600) verbunden. Auch hier wird wieder eine von der Zeit t abhängige gepulste Spannung V angelegt, die zeitlich variabel verändert werden kann und so zu einer Dynamisierung der Helligkeit führt.

Die in den Fig. 2a bis 2d gezeigten verschiedenen Ausführungsformen von Elektrodenflächen können z. B. auch in einer Vorrichtung miteinander kombiniert werden, so dass z. B. eine in diesen Figuren gezeigte Elektrodenfläche die erste Elektrodenfläche und eine andere in den Figuren gezeigte Elektrodenfläche die zweite Elektrodenfläche der Vorrichtung darstellt. Weiterhin können diese verschiedenen Ausführungsformen auch in einer Elektrodenfläche miteinander kombiniert werden.

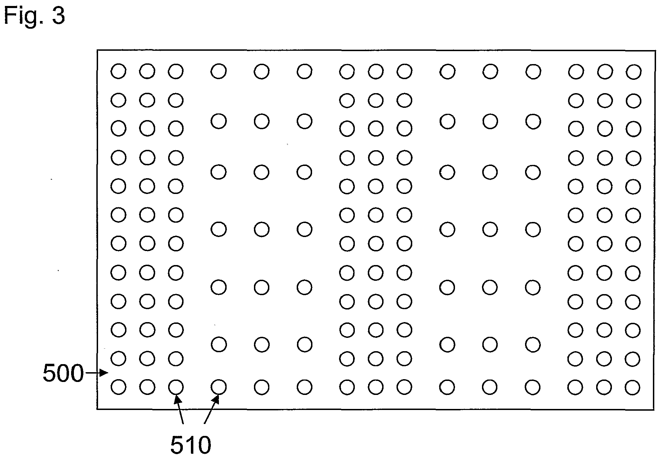

Figur 3 zeigt ein Beispiel für eine passive Modulation der Leuchtdichte. Es wird die Aufsicht auf eine lichtauskoppelnde Schicht (500) gezeigt, die vorteilhafterweise im Strahlengang der lichtemittierenden Schicht (220) angeordnet ist und eine Vielzahl von optischen Elementen (510) enthält. Diese Schicht (500) kann in Figur 1 beispielsweise auf der der funktionellen Schicht (200) abgewandten Hauptoberfläche des Substrats (400) bei einer sog. "bottom-emitting" (nach unten emittierenden) Vorrichtung angeordnet sein oder z. B. auf einer in Fig. 1 nicht gezeigten Verkapselung der Schichtenfolge (100), (200) und (300) bei einer "topemitting" (nach oben emittierenden) Vorrichtung vorhanden sein. Diese optischen Elemente befinden sich auf der Lichtaustrittfläche der lichtauskoppelnden Schicht und weisen eine über die Oberfläche laterale Verteilung auf. Auch ihre geometrische Ausformung kann eine Verteilung aufweisen. Die optischen Elemente umfassen Linsen, Prismen, Zylinder und Streupartikel oder beliebige Kombinationen davon. Neben normalen Linsen ist auch der Einsatz von Fresnellinsen vorstellbar. Eine Geometrievariation der Streupartikel, die beispielsweise Kunststoff- oder TiO₂-Partikel oder lichtabsorbierendes Material sein können kann beispielsweise durch mehrmaliges Bedrucken oder Rakeln von unterschiedlichen Partikellösungen mit den gewünschten Geometrien auf eine lichtemittierende Vorrichtung durch geeignete Masken realisiert werden. Durch diese Anordnung wird eine örtliche, statische Variation der Helligkeit erzeugt, da die lichtauskoppelnde Schicht stark strukturiert wird. Auch der Farbort kann periodisch moduliert werden, beispielsweise durch den Spitzenwinkel eines Prismas. Die Verteilungsdichte sowie die Geometrievariation können ein- und zweidimensional entlang der Breite und der Länge der lichtauskoppelnden Schicht erfolgen, wobei die Verteilungsschwankungen im Bereich einiger Zentimeter bis hin zu Metern liegen können. Die in Figur 3 gezeigten optischen Elemente sind schematisch dargestellte Linsen, die eine über die Oberfläche unterschiedliche laterale Verteilung aufweisen. Es können alternativ oder zusätzlich auch andere optische Elemente auf der lichtauskoppelnden Schicht vorhanden sein.

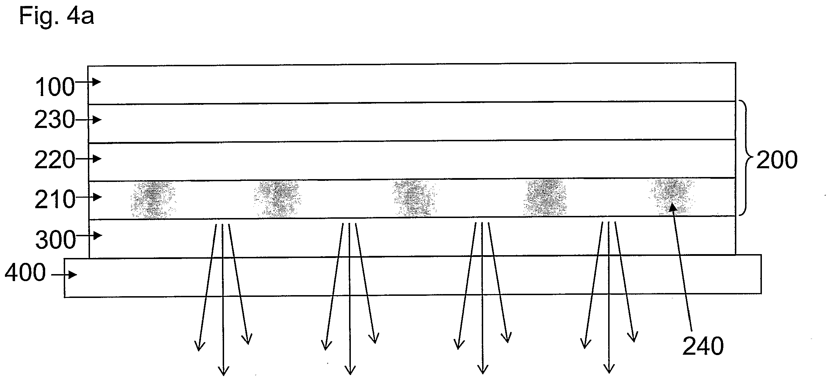

Figur 4a zeigt den Querschnitt einer lichtemittierenden Vorrichtung, beispielsweise einer OLED, bei der auf einem Substrat (400) eine erste Elektrodenfläche (300), eine erste Ladungstransportschicht (210) eine lichtemittierende Funktionsschicht (220), eine zweite Ladungstransportschicht (230) und eine zweite Elektrodenfläche (100) angeordnet sind. Dabei können die erste (210) und zweite (230) Ladungstransportschicht und die lichtemittierende Funktionsschicht (220) Teil der organischen Schichtenfolge (200) sein. Die erste Ladungstransportschicht umfasst einen Dotierstoff (240) der eine laterale Dichteschwankung aufweist. Durch diese örtliche Schwankung des Dotierungsgrades wird eine lateral variierende Leitfähigkeit der ersten Ladungstransportschicht erzeugt, die zu einer Helligkeitsmodifikation führt. Die Schwankung des Dotierungsgrades kann beispielsweise durch Bedampfen der Ladungstransportschicht mit Schattierungsmasken erreicht werden. Der Bereich der variierenden Dotierung liegt bei wenigen Prozent vom Maximalwert der Dotierungskonzentration, die wiederum typischerweise weniger als 10 Volumenprozent in der Ladungstransportschicht beträgt.

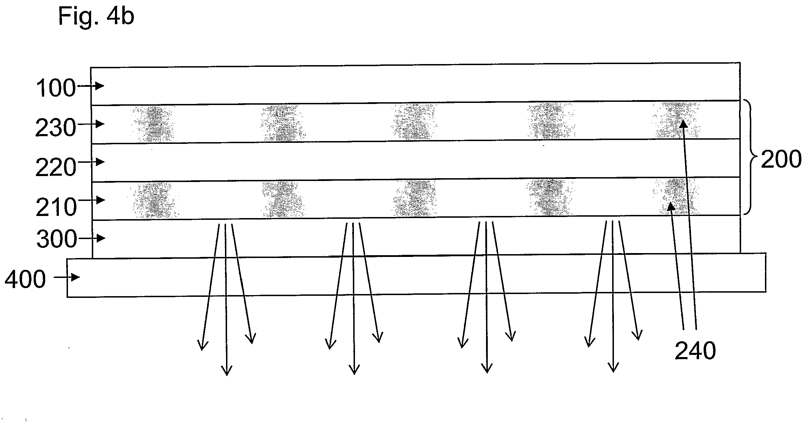

Figur 4b zeigt eine weitere vorteilhafte Form dieses Beispiels. Hier ist auch die zweite Ladungstransportschicht (230) mit einem Dotierstoff (240) versehen, der eine räumliche Modifikation aufweist die zu einer örtlichen Variation der Leitfähigkeit und damit der Helligkeit führt.

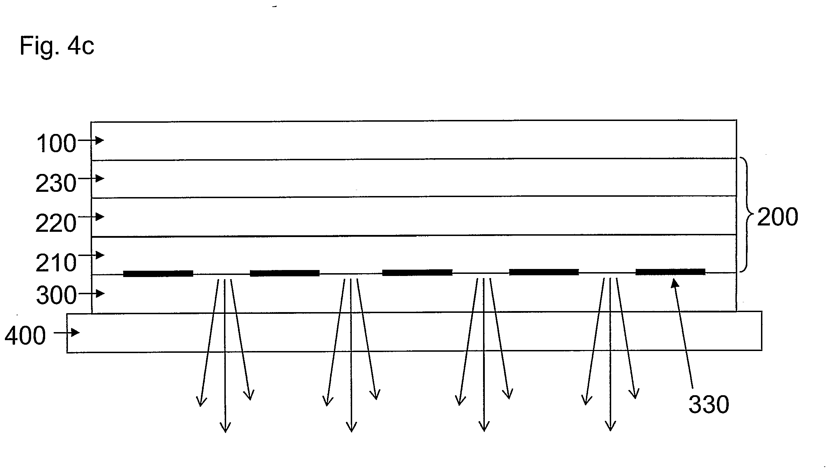

Figur 4c zeigt ein weiteres Beispiel. Es ist wieder der Querschnitt einer lichtemittierenden Vorrichtung zu sehen, bei der die Oberfläche der ersten Elektrodenfläche (300) eine laterale Oberflächenmodifikation (330) aufweist. Das kann beispielsweise eine strukturierte Photolackschicht sein, die auf der Elektrodenoberfläche aufgebracht ist. Dadurch wird die in die zumindest eine funktionelle Schicht bei Anlagen einer Spannung injizierte Ladungsträgerdichte örtlich variiert. Die Oberflächenmodifikation kann beispielsweise durch einen lithographischen Prozess, wie Plasmaätzen der Elektrodenfläche, erreicht werden. Die Oberflächenmodifikation bewirkt eine örtliche Modifikation der Injektion der Ladungsträger und damit zu einer örtlichen Variation der Ladungsträgerdichte. Diese bewirkt weiterhin eine Modifikation der Ladungsträgerrekombination und damit der Helligkeit.

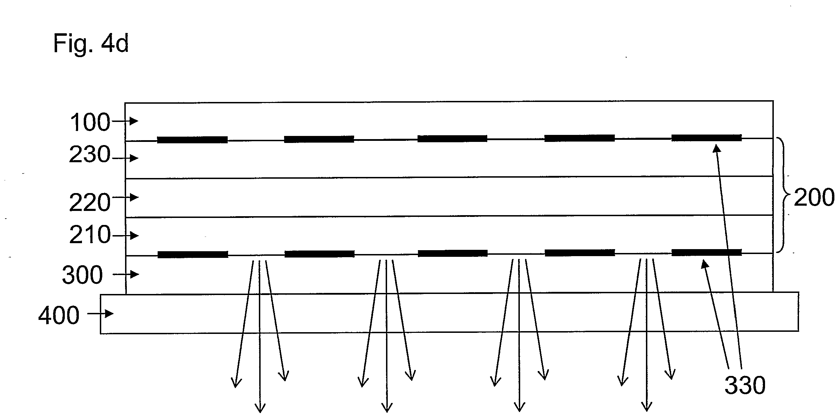

Figur 4d zeigt eine erfindungsgemäße Variante des in Figur 4c beschriebenen Beispiels. Hier weist auch die Oberfläche der zweiten Elektrodenfläche (100) Oberflächenmodifikationen (330) auf, die ebenfalls zu einer modifizierten Oberflächenleitfähigkeit und damit zu einer örtlich variierenden Injektion von Ladungsträgern bei Anlegen einer Spannung führt.

Die Modifikation der Leitfähigkeit im Volumen bzw. auf der Elektrode, wie in den Figuren 4a bis 4d vorgeschlagen, ist lateral z. B. in einer Größenordnung von einigen wenigen bis hin zu mehreren 10 Zentimetern vorstellbar.

Die in den Figuren 1 bis 4 gezeigten Beispiele können auch beliebig variiert und kombiniert in einer lichtemittierenden Vorrichtung eingesetzt werden.

## Patentansprüche

1. Lichtemittierende Vorrichtung mit zeitlich und/oder örtlich variabel einstellbarer Leuchtdichte, umfassend
- ein Substrat (400),
- eine erste Elektrodenfläche (300) auf dem Substrat,
- zumindest zwei elektrisch leitfähige Leiterbahnen (320) unter, in oder auf der ersten Elektrodenfläche (300), die im elektrischen Kontakt mit der ersten Elektrodenfläche stehen und über die erste Elektrodenfläche hinausragen,
- zumindest eine organische Schicht (200), die eine lichtemittierende Funktionsschicht (220) umfasst, auf der ersten Elektrodenfläche und
- eine zweite Elektrodenfläche (100) auf der lichtemittierenden Funktionsschicht,
wobei die zumindest zwei leitfähigen Leiterbahnen so eingerichtet sind, dass sie mit zeitlich und/oder örtlich variablen und/oder unterschiedlich hohen elektrischen Strömen angesteuert werden können, wobei eine variierende Leuchtdichte resultiert,
**dadurch gekennzeichnet, dass**
die zumindest zwei elektrisch leitenden Leiterbahnen (320) so dick sind, dass sie die erste Elektrodenfläche (300), die organische Schicht (200) und die zweite Elektrodenfläche (100) durchstoßen, und dass die zumindest zwei elektrisch leitenden Leiterbahnen an den seitlichen Rändern zur organischen Schicht und der zweiten Elektrodenfläche hin mit einer nicht-leitenden Polymerschicht ummantelt sind.

2. Vorrichtung nach dem vorhergehenden Anspruch, bei der die Leiterbahnen (320) in einem Abstand von 5 µm bis 10 cm, vorzugsweise 500 µm bis 1 cm zueinander auf der ersten Elektrodenfläche (300) angeordnet sind und eine unterschiedliche Länge aufweisen.

3. Vorrichtung nach einem der vorhergehenden Ansprüche, wobei die zumindest zwei Leiterbahnen (320) getrennt voneinander elektrisch ansteuerbar sind.

4. Vorrichtung nach einem der vorhergehenden Ansprüche, mit zumindest einer Stromquelle (600), die elektrisch leitend mit den Leiterbahnen (320) verbunden ist, wobei das Ausgangssignal der Stromquelle auf eine für die zumindest zwei Leiterbahnen individuelle Modulationsfrequenz einstellbar ist.

5. Vorrichtung nach einem der vorhergehenden Ansprüche, wobei die Leiterbahnen (320) elektrische Anschlüsse (310) zur Kontaktierung einer Stromquelle (600) aufweisen und diese elektrischen Anschlüsse an unterschiedlichen Enden der Leiterbahnen vorhanden sind.

6. Vorrichtung nach einem der vorhergehenden Ansprüche, mit zumindest einer ersten und einer zweiten Gruppe von elektrisch leitfähigen Leiterbahnen (320), wobei die Leiterbahnen einer Gruppe elektrisch leitend miteinander verbunden sind.

7. Vorrichtung nach Anspruch 6, wobei jede der zumindest zwei Gruppen von Leiterbahnen (320) mit einer anderen Stromquelle (600) elektrisch leitend verbunden ist, wobei die Ausgangssignale der Stromquellen unabhängig voneinander modulierbar sind.

8. Vorrichtung nach Anspruch 6, wobei die zumindest zwei Gruppen von Leiterbahnen (320) elektrisch leitend mit einer gemeinsamen Stromquelle (600) verbunden sind, deren Ausgangsignal modulierbar ist.

9. Vorrichtung nach einem der vorhergehenden Ansprüche, wobei zusätzlich eine lichtauskoppelnde Schicht (500) mit einer Vielzahl von optischen Elementen (510) im Strahlengang der lichtemittierenden Funktionsschicht (220) vorhanden ist.

10. Vorrichtung nach dem vorhergehenden Anspruch, bei der die Vielzahl der optischen Elemente (510) auf einer Hauptoberfläche der lichtauskoppelnden Schicht (500) angeordnet sind und die optischen Elemente eine über die Oberfläche unterschiedliche Verteilung und/oder geometrische Ausformung aufweisen.

11. Vorrichtung nach einem der vorhergehenden Ansprüche, bei der zusätzlich zwischen der ersten Elektrodenfläche (300) und der zumindest einen lichtemittierenden Funktionsschicht (220) eine erste Ladungstransportschicht (210) vorhanden ist, wobei die erste Ladungstransportschicht Teilbereiche mit einer unterschiedlichen elektrischen Leitfähigkeit aufweist.

12. Vorrichtung nach einem der vorhergehenden Ansprüche, bei der zusätzlich die Oberfläche der ersten Elektrodenfläche (300) eine in lateraler Richtung variierende elektrische Leitfähigkeit aufweist.

13. Vorrichtung nach dem vorhergehenden Anspruch, wobei die Oberfläche der ersten Elektrodenfläche (300) eine in lateraler Richtung variierende Oberflächenmodifikation (330) aufweist.

14. Lichtemittierende Vorrichtung mit variierender Leuchtdichte, umfassend
- ein Substrat (400),
- eine erste Elektrodenfläche (300) auf dem Substrat,
- zumindest eine lichtemittierende Funktionsschicht (220) auf der ersten Elektrodenfläche,
- eine zweite Elektrodenfläche (100) auf der lichtemittierenden Funktionsschicht,
wobei die erste und zweite Elektrodenfläche eine in lateraler Richtung variierende elektrische Leitfähigkeit aufweist, **dadurch gekennzeichnet, dass**
die Oberfläche der ersten (300) und zweiten Elektrodenfläche (100) in lateraler Richtung variierende Oberflächenmodifikationen (330) aufweisen,
wobei die Oberflächenmodifikationen durch eine strukturierte Photolackschicht gebildet sind, welche auf der ersten (300) und zweiten Elektrodenfläche (100) aufgebracht ist.

15. Vorrichtung nach dem vorhergehenden Anspruch, wobei die variierende Oberflächenmodifikationen (330) durch eine lokal modifizierte Landungsträgeraustrittsarbeit und/oder einen lokal modifizierten Oberflächenwiderstand gebildet wird.

## Claims

1. Light emitting device with temporally and/or locally variably adjustable luminance, comprising
- a substrate (400),
- a first electrode surface (300) on the substrate,
- at least two electrically conductive conductor tracks (320) under, in or on the first electrode surface (300), which are in electrical contact with the first electrode surface and project beyond the first electrode surface,
- at least one organic layer (200) comprising a light-emitting functional layer (220) on the first electrode surface and
- a second electrode surface (100) on the light-emitting functional layer,
the at least two conductive conductor tracks being arranged such that they can be controlled with electrical currents which vary in time and/or location and/or are of different levels, resulting in a varying luminance,
**characterized in that**
the at least two electrically conductive conductor tracks (320) are thick enough to penetrate the first electrode surface (300), the organic layer (200) and the second electrode surface (100), and **in that** the at least two electrically conductive conductor tracks at the lateral edges towards the organic layer and the second electrode surface are coated with a non-conductive polymer layer.

2. The device according to the preceding claim, in which the conductor tracks (320) are arranged at a distance of 5 µm to 10 cm, preferably 500 µm to 1 cm from one another on the first electrode surface (300) and have a different length.

3. The device according to any of the preceding claims, the at least two conductor tracks (320) being electrically controllable separately from one another.

4. The device according to any of the preceding claims, comprising at least one current source (600) electrically conductively connected to the conductor tracks (320), the output signal of the current source being adjustable to a modulation frequency individual for the at least two conductor tracks.

5. The device according to any of the preceding claims, said conductor tracks (320) having electrical terminals (310) for contacting a current source (600) and said electrical terminals being provided at different ends of said conductor tracks.

6. The device according to one of the preceding claims, comprising at least a first and a second group of electrically conductive conductor tracks (320), wherein the conductor tracks of one group are electrically conductively connected to one another.

7. The device according to claim 6, each of the at least two groups of conductor tracks (320) being electrically conductively connected to another current source (600), the output signals of the current sources being modulable independently from each other.

8. The device according to claim 6, wherein the at least two groups of conductor tracks (320) are electrically conductively connected to a common current source (600) whose output signal is modulable.

9. The device according to any of the preceding claims, wherein additionally a light-outoupling layer (500) with a plurality of optical elements (510) is provided in the beam path of the light-emitting functional layer (220).

10. The device according to the preceding claim, in which the plurality of the optical elements (510) are arranged on a main surface of the light-outcoupling layer (500) and the optical elements have a different distribution and/or geometric shape across the surface.

11. The device according to one of the preceding claims, in which additionally between the first electrode surface (300) and the at least one light-emitting functional layer (220) a first charge transport layer (210) is present, wherein the first charge transport layer has partial regions with a different electrical conductivity.

12. The device according to one of the preceding claims, in which additionally the surface of the first electrode surface (300) has an electrical conductivity varying in the lateral direction.

13. The device according to the preceding claim, the surface of the first electrode surface (300) having a surface modification (330) varying in the lateral direction.

14. Light emitting device with variable luminance comprising
- a substrate (400),
- a first electrode surface (300) on the substrate,
- at least one light-emitting functional layer (220) on the first electrode surface,
- a second electrode surface (100) on the light-emitting functional layer,
the first and second electrode surfaces having an electrical conductivity varying in the lateral direction, **characterized in that** the surface of the first (300) and second electrode surfaces (100) have surface modifications (330) that vary in the lateral direction,
the surface modifications being formed by a structured photoresist layer applied to the first (300) and second electrode surfaces (100).

15. The device according to the preceding claim, wherein the varying surface modifications (330) are formed by a locally modified charge carrier work function and/or a locally modified surface resistance.

## Revendications

1. Dispositif émetteur de lumière doté d'une densité lumineuse réglable, variable temporellement et/ou localement, comprenant
- un substrat (400),
- une première surface d'électrode (300) sur le substrat,
- au moins deux pistes (320) conductrices électriquement conductibles au-dessous, dans ou sur la première surface d'électrode (300), lesquelles sont en contact électrique avec la première surface d'électrode et font saillie au-delà de la première surface d'électrode,
- au moins une couche organique (200), qui comprend une couche fonctionnelle (220) émettrice de lumière, sur la première surface d'électrode, et
- une deuxième surface d'électrode (100) sur la couche fonctionnelle émettrice de lumière,
les aux moins deux pistes conductrices étant conçues de manière à ce qu'elles puissent être commandées avec des courant électriques temporellement et/ou localement variables et/ou différemment élevés, une densité lumineuse variant en étant le résultat,
**caractérisé en ce que**
les aux moins deux pistes (320) conductrices électriquement conductibles sont tellement épaisses qu'elles pénètrent la première surface d'électrode (320), la couche organique (200) et la deuxième surface d'électrode (100), et **en ce que** les aux moins deux pistes conductrices électriquement conductibles, sur les bords latéraux en direction de la couche organique et de la deuxième surface d'électrode, sont enrobées par une couche polymère non conductrice.

2. Dispositif selon la revendication précédente, dans lequel les pistes (320) conductrices sont disposées sur la première surface d'électrode (300) avec un écart de 5 µm à 10 cm, de préférence de 500 µm à 1 cm, l'une par rapport à l'autre et présentent une longueur différente.

3. Dispositif selon l'une quelconque des revendications précédentes, dans lequel les aux moins deux pistes (320) conductrices sont commandables électriquement de manière séparée l'une de l'autre.

4. Dispositif selon l'une quelconque des revendications précédentes, comprenant au moins une source de courant (600) qui est reliée aux pistes (320) conductrices de manière électro-conductrice, le signal de sortie de la source de courant étant réglable sur une fréquence de modulation individuelle pour les aux moins deux pistes conductrices.

5. Dispositif selon l'une quelconque des revendications précédentes, les pistes (320) conductrices présentant des raccordements électriques (310) pour la mise en contact d'une source de courant (600), et ces raccordements électriques étant présents sur différentes extrémités des pistes conductrices.

6. Dispositif selon l'une quelconque des revendications précédentes, comprenant au moins un premier et un deuxième groupe de pistes (320) conductrices électriquement conductibles, les pistes conductrices d'un groupe étant reliées entre elles de manière électro-conductrice.

7. Dispositif selon la revendication 6, chacun des aux moins deux groupes de pistes (320) conductrices étant relié de manière électro-conductrice à une autre source de courant (600), les signaux de sortie des sources de courant étant modulables indépendamment les uns des autres.

8. Dispositif selon la revendication 6, les aux moins deux groupes de pistes (320) conductrices étant reliés de manière électro-conductrice à une source de courant commune, dont le signal de sortie est modulable.

9. Dispositif selon l'une quelconque des revendications précédentes, une couche (500) découplant la lumière, munie d'une pluralité d'éléments optiques (510), étant en plus présente dans le trajet du faisceau de la couche fonctionnelle (220) émettrice de lumière.

10. Dispositif selon la revendication précédente, dans lequel la pluralité d'éléments optiques (510) est disposée sur une surface principale de la couche (500) découplant la lumière, et dans lequel les éléments optiques présentent sur la surface une répartition différente et/ou une forme géométrique différente.

11. Dispositif selon l'une quelconque des revendications précédentes, dans lequel une première couche de transport de charge (210) est en plus présente entre la première surface d'électrode (330) et l'au moins une couche fonctionnelle (220) émettrice de lumière, la première couche de transport de charge présentant des zones partielles ayant une conductivité électrique différente.

12. Dispositif selon l'une quelconque des revendications précédentes, dans lequel la surface de la première surface d'électrode (300) présente en plus une conductivité électrique variant en direction latérale.

13. Dispositif selon la revendication précédente, la surface de la première surface d'électrode (300) présentant une modification de surface (330) variant en direction latérale.

14. Dispositif émetteur de lumière à intensité lumineuse variant, comprenant
- un substrat (400),
- une première surface d'électrode (300) sur le substrat,
- au moins une couche fonctionnelle (220) émettrice de lumière, sur la première surface d'électrode,
- une deuxième surface d'électrode (100) sur la couche fonctionnelle émettrice de lumière,
la première et la deuxième surfaces d'électrode présentant une conductivité électrique variant en direction latérale, **caractérisé en ce que**
la surface de la première surface d'électrode (300) et de la deuxième surface d'électrode (100) présente des modifications de surface (330) variant en direction latérale,
les modifications de surface étant formées par une couche de laque photosensible structurée, laquelle est appliquée sur la première surface d'électrode (300) et sur la deuxième surface d'électrode (100).

15. Dispositif selon la revendication précédente, les modifications de surface (330) variant étant formées par un travail de sortie de porteur de charge localement modifié et/ou par une résistance de surface localement modifiée.
